(19) Europäisches Patentamt
European Patent Office
Office européen des brevets

(11) **EP 4 325 307 A1**

(12) **EUROPÄISCHE PATENTANMELDUNG**

(43) Veröffentlichungstag:
**21.02.2024 Patentblatt 2024/08**

(21) Anmeldenummer: **23191462.3**

(22) Anmeldetag: **15.08.2023**

(51) Internationale Patentklassifikation (IPC):
**G05B 19/042** (2006.01)

(52) Gemeinsame Patentklassifikation (CPC):
**G05B 19/0426**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**KH MA MD TN**

(30) Priorität: **16.08.2022 DE 102022120665**

(71) Anmelder: **Pilz GmbH & Co. KG**
**73760 Ostfildern (DE)**

(72) Erfinder:
• **Lenz, Markus**
**73760 Ostfildern (DE)**
• **Schnaithmann, Martin**
**73760 Ostfildern (DE)**

(74) Vertreter: **Witte, Weller & Partner Patentanwälte mbB**
**Postfach 10 54 62**
**70047 Stuttgart (DE)**

(54) **KONFIGURATION IN REIHE GESCHALTETER ELEKTRISCHER GERÄTE**

(57)    Vorrichtung (100) mit einer Vielzahl von elektrischen Geräten (10; 10A, 10B, 10C), die jeweils hinsichtlich einer Stellgröße konfigurierbar sind, wobei die elektrischen Geräte (10; 10A, 10B, 10C) jeweils einen Eingang (12) zum Anlegen eines Eingangssignals, einen Ausgang (14) zum Bereitstellen eines Ausgangssignals sowie eine Messeinrichtung (24) zum Bestimmen einer an dem jeweiligen elektrischen Gerät (10; 10A, 10B, 10C) anliegenden Spannung, aufweisen. Die elektrischen Geräte (10; 10A, 10B, 10C) sind in einer Reihenschaltung anordenbar, bei der ein erstes elektrisches Gerät (10A) der elektrischen Geräte (10; 10A, 10B, 10C) mit einem für die Reihenschaltung maßgeblichen Eingangssignal verbindbar ist und jedes weitere elektrische Gerät (10B, 10C) jeweils mit dem Eingang (12) an den Ausgang (14) eines vorherigen elektrischen Geräts der Reihenschaltung verbunden ist. Innerhalb jedes elektrischen Geräts (10; 10A, 10B, 10C) ist der jeweilige Eingang (12) mit dem zugehörigen Ausgang (14) so gekoppelt, dass sich ein definierter Spannungsabfall zwischen dem jeweiligen Eingang (12) und dem zugehörigen Ausgang (14) einstellt, wenn an dem jeweiligen Eingang (12) ein definiertes Potential (16) anliegt. Die elektrischen Geräte (10; 10A, 10B, 10C) konfigurieren jeweils anhand der gemessenen anliegenden Spannung eine für das Gerät relevante Stellgröße.

Fig. 1

EP 4 325 307 A1

**Beschreibung**

Die vorliegende Erfindung betrifft ein Verfahren zur Konfiguration einer Stellgröße einer Vielzahl von elektrischen Geräten, die in einer Reihe geschaltet sind, sowie eine entsprechende Vorrichtung mit einer Vielzahl von elektrischen Geräten, die jeweils hinsichtlich einer Stellgröße konfigurierbar sind.

Reihenschaltungen elektrischer Geräte werden für verschiedene Anwendungen unter anderem im Bereich der Automatisierungstechnik eingesetzt und haben den Vorteil, dass regelmäßig ein Verdrahtungsaufwand gegenüber einer Einzelverdrahtung der elektrischen Geräte reduziert werden kann. Ferner sind Reihenschaltungen immer dann vorteilhaft, wenn mit den elektrischen Geräten das Prinzip einer Kette nachempfunden werden soll, bspw. im Sinne einer UND-Verknüpfung der elektrischen Geräte.

Bei einer Reihenschaltung verfügen die einzelnen elektrischen Geräte jeweils über mindestens einen Eingang, an dem ein Signal aufgenommen werden kann, und einen Ausgang, an dem in Abhängigkeit eines am Eingang anliegenden Signals ein Ausgangssignal bereitgestellt wird. Ferner sind die elektrischen Geräte so verschaltet, dass ein Ausgang eines Geräts mit dem Eingang eines nachfolgenden Geräts verbunden ist, um eine Kette zu bilden. Ein an dem Eingang eines ersten Geräts der Kette angelegtes Signal wird dann über die beschriebene Verknüpfung der Ein- und Ausgänge von einem Gerät zum nächsten Gerät übertragen.

Für verschiedene Anwendungen ist es notwendig, die einzelnen Geräte einer Reihenschaltung individuell zu konfigurieren. Bspw. müssen für einzelne Anwendungen den einzelnen Geräten ihre relative oder absolute Position innerhalb der Kette bekannt sein, um ihre jeweilige Tätigkeit ausführen zu können. Eine solche Konfiguration kann auf einfache Weise über Dip-Schalter an den einzelnen Geräten manuell erfolgen. Alternativ kann eine Konfiguration auch in einem Speicher der einzelnen Einheit hinterlegt sein. Neben einer manuellen Konfiguration ist auch eine automatische Konfiguration möglich, wenn die Geräte untereinander kommunizieren können.

Die manuelle Konfiguration hat den Vorteil, dass sie sich einfach realisieren lässt, jedoch beim Hinzufügen oder Entfernen eines Geräts oder beim Tauschen der Positionen untereinander jedes Mal erneut von Hand durchgeführt werden muss. Bekannte Verfahren zur automatischen Konfiguration sind demgegenüber flexibler, jedoch auch wesentlich aufwendiger in der Realisierung.

Es ist daher eine Aufgabe, ein Verfahren und eine entsprechende Vorrichtung anzugeben, die eine Konfiguration der einzelnen Geräte einer Reihenschaltung auf einfache Weise ermöglichen, sich leicht und kostengünstig realisieren lassen und flexibel Veränderungen der Reihenschaltung berücksichtigen können.

Gemäß einem Aspekt der vorliegenden Erfindung wird diese Aufgabe gelöst durch eine Vorrichtung mit einer Vielzahl von elektrischen Geräten, die jeweils hinsichtlich einer Stellgröße konfigurierbar sind, wobei die elektrischen Geräte jeweils einen Eingang zum Anlegen eines Eingangssignals, einen Ausgang zum Bereitstellen eines Ausgangssignals sowie eine Messeinrichtung zum Bestimmen einer an dem jeweiligen elektrischen Gerät anliegenden Spannung, aufweisen. Die elektrischen Geräte sind in einer Reihenschaltung anordenbar, bei der ein erstes elektrisches Gerät der elektrischen Geräte mit einem für die Reihenschaltung maßgeblichen Eingangssignal verbindbar ist und jedes weitere elektrische Gerät jeweils mit dem Eingang an den Ausgang eines vorherigen elektrischen Geräts der Reihenschaltung verbunden ist. Innerhalb jedes elektrischen Geräts ist der jeweilige Eingang mit dem zugehörigen Ausgang so gekoppelt, dass sich ein definierter Spannungsabfall zwischen dem jeweiligen Eingang und dem zugehörigen Ausgang einstellt, wenn an dem jeweiligen Eingang ein definiertes Potential anliegt. Die elektrischen Geräte konfigurieren jeweils anhand der gemessenen anliegenden Spannung eine für das Gerät relevante Stellgröße.

Gemäß einem weiteren Aspekt wird die Aufgabe gelöst durch ein elektrisches Gerät einer Reihenschaltung, das hinsichtlich einer Stellgröße konfigurierbar ist, aufweisend einen Eingang zum Anlegen eines Eingangssignals, einen Ausgang zum Bereitstellen eines Ausgangssignals sowie eine Messeinrichtung zum Bestimmen einer an dem elektrischen Gerät anliegenden Spannung, wobei das elektrische Gerät in einer Reihenschaltung anordenbar ist, bei der ein erstes elektrisches Gerät der Reihenschaltung mit einem für die Reihenschaltung maßgeblichen Eingangssignal verbindbar ist und jedes weitere elektrische Gerät der Reihenschaltung jeweils mit dem Eingang an den Ausgang eines vorherigen elektrischen Geräts der Reihenschaltung verbunden ist, wobei innerhalb des elektrischen Geräts der Eingang mit dem Ausgang so gekoppelt ist, dass sich ein definierter Spannungsabfall zwischen dem Eingang und dem Ausgang einstellt, wenn an dem Eingang ein definiertes Potential anliegt, und wobei das elektrische Gerät anhand der gemessenen anliegenden Spannung eine für das elektrische Gerät relevante Stellgröße konfiguriert.

Gemäß einem weiteren Aspekt wird die Aufgabe ferner gelöst durch ein Verfahren zur Konfiguration einer Stellgröße in einer Vielzahl in Reihe geschalteter elektrischer Geräte, mit den Schritten

- Bereitstellen der elektrischen Geräte, die jeweils einen Eingang zum Anlegen eines Eingangssignals, einen Ausgang zum Bereitstellen eines Ausgangssignals sowie eine Messeinrichtung zum Bestimmen einer an dem jeweiligen elektrischen Gerät anliegenden Spannung, aufweisen,

- Anordnen der elektrischen Geräte in einer Reihenschaltung, bei der ein erstes elektrisches Gerät der elektrischen Geräte mit einem für die Reihenschaltung maßgeblichen Eingangssignal verbindbar ist und jedes weitere elektrische Gerät jeweils mit seinem Eingang an den Ausgang eines vorherigen elektrischen Geräts der Reihenschaltung verbunden ist,

wobei jeder Eingang der elektrischen Geräte mit dem zugehörigen Ausgang so gekoppelt ist, dass sich ein definierter Spannungsabfall zwischen dem jeweiligen Eingang und dem zugehörigen Ausgang einstellt, wenn an dem jeweiligen Eingang ein definiertes Potential anliegt, wobei die elektrischen Geräte jeweils anhand der gemessenen anliegenden Spannung eine für das Gerät relevante Stellgröße konfigurieren.

Es ist somit eine Idee der vorliegenden Erfindung die elektrischen Geräte einer Reihenschaltung über eine an den Geräten gemessene Spannung einzustellen. Hierfür sind die Geräte so eingerichtet, dass sich zwischen der Spannung am Eingang und der Spannung am Ausgang innerhalb des einzelnen Geräts ein Spannungsabfall einstellt, sodass über die Reihenschaltung eine Spannungskaskade entsteht. Wird folglich am Eingang des ersten Geräts der Reihenschaltung eine konstante Spannung angelegt, stellt sich an dem jeweiligen einzelnen Gerät der Reihenschaltung eine um die Spannungsabfälle der vorherigen Geräte verringerte Eingangsspannung ein. Sind die Spannungsabfälle entsprechend eingestellt, unterscheidet sich dadurch die Eingangsspannung an dem einzelnen Gerät von der Eingangsspannung an den jeweils anderen Geräten. Mit anderen Worten, durch die Spannungskaskade liegt an jedem Gerät eine andere Spannung an, die eindeutig innerhalb der Reihenschaltung ist.

Diese Eindeutigkeit kann genutzt werden, um dem einzelnen Gerät basierend auf der gemessenen Spannung einen eindeutigen Wert zuzuordnen. Das einzelne Gerät lässt sich somit mit einem eindeutigen Wert konfigurieren. Vorteilhaft kann dieser Wert kontinuierlich bestimmt werden, ohne dass dieser in einem Speicher des Geräts hinterlegt werden muss.

Zudem ermöglicht die Konfiguration über die Spannungskaskade, dass sich der Wert dynamisch an eine Veränderung der Reihenschaltung (Hinzufügen, Entfernen, Vertauschen einzelner Geräte) anpasst, jedoch stets eindeutig innerhalb der Reihenschaltung bleibt. Die Anpassung kann dabei automatisch erfolgen, ohne dass ein manueller Eingriff erforderlich ist.

Ferner, da für die Konfiguration lediglich ein definierter Spannungsabfall an den einzelnen Geräten sowie eine einfache Spannungsmesseinrichtung erforderlich sind, kann auf komplizierte Ein- und Ausgangsschaltungen verzichtet werden. Vorteilhaft können innerhalb der einzelnen Geräte der Eingang und der Ausgang im Wesentlichen direkt miteinander verbunden sein mit lediglich einem passiven Element dazwischen, welches den insbesondere konstanten Spannungsabfall verursacht. Die Ein/Ausgangsschaltung kann somit einfach und kleinbauend ausgestaltet sein, wodurch die Gesamtgröße der einzelnen Geräte positiv verringert werden kann. Eine einfache Ein/Ausgangsschaltung hat zudem den Vorteil, dass sie hinsichtlich elektromechanischer Verträglichkeit (EMV) robuster ist als dedizierte Eingangsschaltungen und Ausgangsschaltungen in Digitaltechnik. Die eingangs genannte Aufgabe ist somit vollständig gelöst.

In einer weiteren Ausgestaltung kann das Eingangssignal einen Zustand für die Reihenschaltung repräsentieren, in dessen Abhängigkeit die elektrischen Geräte eine Aktion ausführen, wobei die Aktionsausführung ferner von der konfigurierten Stellgröße abhängig ist. Das Eingangssignal muss somit kein speziell für die Konfiguration hergerichtetes Eingangssignal sein, sondern kann ein Signal sein, dass betriebsbedingt an den elektrischen Geräten anliegt. Insbesondere kann das Eingangssignal ein Steuersignal sein, anhand dessen allein oder in Kombination mit weiteren Signalen die elektrischen Geräte eine Steuerfunktion ausführen. Der grundsätzliche Aufbau einer Reihenschaltung muss folglich durch die Verwendung der neuen Ein/Ausgangsschaltung nicht verändert werden.

In einer bevorzugten Weiterbildung kann die Aktion eine Schaltfunktion gegen ein der Reihenschaltung gemeinsames Potential sein, wobei die Stellgröße eine Zeitvariable ist, insbesondere eine Verzögerungszeit, anhand derer ein Schaltzeitpunkt bestimmbar ist. Durch die Eindeutigkeit der Stellgröße innerhalb der Reihenschaltung kann auf diese Weise gewährleistet werden, dass die Schaltfunktion jeweils zeitversetzt in den elektrischen Geräten ausgeführt wird.

In einer weiteren Ausgestaltung kann zwischen dem jeweiligen Eingang und dem zugehörigen Ausgang der elektrischen Geräte ein elektrisches Bauelement, insbesondere eine Schottky-Diode, angeordnet sein, welches den definierten Spannungsabfall zwischen dem jeweiligen Eingang und dem zugehörigen Ausgang verursacht. Da an jedem passiven Bauelement eine Spannung abfällt, wenn es von Strom durchflossen wird, können verschiedene Bauelemente für die Erzeugung des gewünschten Spannungsabfalls zwischen Eingang und Ausgang geschaltet werden. Bevorzugt jedoch ist die Verwendung einer Diode, insbesondere einer Schottky-Diode, für diesen Zweck, da diese vorteilhaft einen kleinen und weitgehend konstanten Spannungsabfall unter variablen Umgebungsbedingungen ermöglicht. Diese Ausgestaltung trägt somit zu einer weiteren Vereinfachung der Ein/Ausgangsschaltung bei.

In einer weiteren Ausgestaltung sind zwischen dem jeweiligen Eingang und dem zugehörigen Ausgang innerhalb der elektrischen Geräte ausschließlich passive Komponenten angeordnet. Die Verwendung von ausschließlich passiven Komponenten hat den Vorteil, dass sich die Ein/Ausgangsschaltung besonders günstig realisieren lässt. Die im Wesentlichen direkte Verbindung zwischen dem Eingang und dem Ausgang hat zudem den Vorteil, dass eine Übertragung vom Eingang zum Ausgang nahezu verzögerungsfrei erfolgt, sodass innerhalb der Reihenschaltung eine schnelle Reaktionszeit gewährleistet werden kann.

In einer bevorzugten Ausgestaltung kann das Eingangssignal an dem jeweiligen Eingang das anliegende definierte Potential bereitstellen. Die für den Spannungsabfall und damit verbunden für die Konfiguration benötigte Spannung kann folglich direkt von einem am Eingang anliegenden Eingangssignal bereitgestellt werden. Dies hat den Vorteil, dass für die Konfiguration keine zusätzliche Spannung zur Verfügung gestellt werden muss.

In einer weiteren Ausgestaltung können die elektrischen Geräte der Reihenschaltung jeweils mit einem der Reihenschaltung gemeinsamen Referenzpotential verbunden sein und der jeweilige Eingang kann über einen ersten Widerstand mit dem Referenzpotential verbunden sein. Das Referenzpotential kann durch eine Verbindung zu einem gemeinsamen Massepotential realisiert werden. Alternativ kann ein Referenzpotential auch wie das Eingangssignal von einem elektrischen Gerät zum anderen elektrischen Gerät übertragen werden. Der erste Widerstand wirkt hierbei als Vorwiderstand, über den sich ein Strom einstellen/begrenzen lässt, der im Zusammenspiel mit einem elektrischen Bauelement den Spannungsabfall definiert. Diese Ausgestaltung trägt somit weiter zu einer einfachen Realisierung des Spannungsabfalls in den einzelnen Geräten bei.

In einer weiteren Ausgestaltung können die elektrischen Geräte der Reihenschaltung jeweils mit einem der Reihenschaltung gemeinsamen Versorgungspotential verbunden sein und der jeweilige Eingang kann über einen zweiten Widerstand mit dem Versorgungspotential verbunden sein. Bevorzugt ist in diesem Fall das über diesen Widerstand aus dem Versorgungspotential ausgekoppelte Potential das definierte Potential, welches an dem jeweiligen Eingang anliegt, wenn der Eingang an dem ersten elektrischen Gerät hochohmig ist, d. h., wenn kein Eingangssignal an dem Eingang des ersten elektrischen Geräts anliegt. Diese Ausgestaltung trägt dazu bei, dass die Konfiguration vorteilhaft nicht allein von dem Vorhandensein eines Eingangssignal abhängig ist. Vielmehr kann auch in dem Fall, dass kein Eingangssignal vorhanden ist, eine Konfiguration gemäß dem zuvor beschriebenen Verfahren erfolgen. Auf diese Weise lassen sich weitere Anwendungen basierend auf diesem Konfigurationsprinzip realisieren.

In einer weiteren Ausgestaltung können die elektrischen Geräte beispielsweise Verriegelungsschalter mit Zuhaltung sein. Verriegelungsschalter werden häufig in Reihenschaltungen verwendet, wobei in verschiedenen Anwendungen es vorteilhaft ist, wenn dem Verriegelungsschalter seine absolute oder relative Position innerhalb der Reihenschaltung bekannt ist. Durch die hier skizzierte einfache Ein/Ausgangsschaltung lässt sich diese hierfür notwendige Konfiguration auf einfache Weise realisieren.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:

Fig. 1   eine schematische Darstellung einer Reihenschaltung gemäß einem Ausführungsbeispiel der vorliegenden Offenbarung,

Fig. 2   eine schematische Darstellung eines elektrischen Geräts mit einer Ein/Ausgangsschaltung gemäß einem Ausführungsbeispiel der vorliegenden Offenbarung,

Fig. 3   eine schematische Darstellung einer Reihenschaltung von Verriegelungsschaltern gemäß einem Ausführungsbeispiel der vorliegenden Offenbarung,

Fig. 4   eine schematische Darstellung eines elektrischen Geräts gemäß Fig. 2 mit einer modifizierten Ein/Ausgangsschaltung,

Fig. 5   eine schematische Darstellung einer Reihenschaltung von Verriegelungsschaltern mit modifizierten Ein/Ausgangsschaltungen,

Fig. 6   eine schematische Darstellung eines Verfahrens gemäß einem Ausführungsbeispiel der vorliegenden Offenbarung.

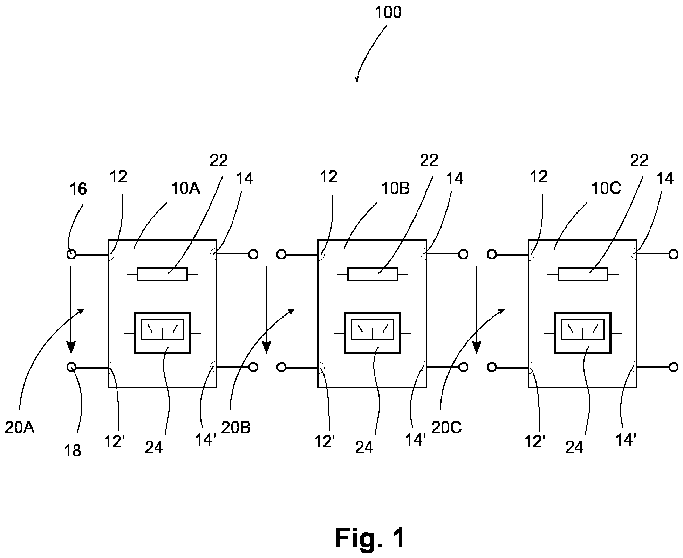

Fig. 1 zeigt in einer schematischen Darstellung eine Reihenschaltung gemäß einem Ausführungsbeispiel der vorliegenden Offenbarung. Die Reihenschaltung ist in ihrer Gesamtheit hier mit der Bezugsziffer 100 bezeichnet.

Die Reihenschaltung setzt sich in diesem Beispiel aus drei einzelnen elektrischen Geräten 10A, 10B, und 10C zusammen. In der nachfolgenden Beschreibung wird die Bezugsziffer 10 verwendet, wenn für alle elektrischen Geräte gemeinsame Elemente beschrieben werden.

Die elektrischen Geräte 10A, 10B und 10C sind für die Reihenschaltung 100 hintereinandergeschaltet. Jedes Gerät 10 weist mindestens einen Eingang 12 sowie einen Ausgang 14 auf. Der Eingang 12 und der Ausgang 14 sind miteinander gekoppelt, sodass ein am Eingang anliegendes Signal (Eingangssignal) an den Ausgang übertragen wird (Ausgangssignal). Wie nachfolgend noch erläutert wird, ist eine direkte Verbindung von Eingang und Ausgang bevorzugt, jedoch grundsätzlich nicht erforderlich für eine Reihenschaltung. Denkbar ist auch, dass an den Eingang eine Eingangsschaltung folgt, die die Eingangssignale aufnimmt, an eine Verarbeitungseinheit weitergibt, welche wiederum eine Ausgangsschaltung basierend auf der Auswertung der Eingangssignale ansteuert, um das Ausgangssignal bereitzustellen.

Der Eingang 12 des ersten elektrischen Geräts 10A kann von einer externen Einheit, beispielsweise einer Steuerung (hier nicht dargestellt) mit einem Eingangssignal belegt werden. Das Eingangssignal kann ein statisches Potential 16 sein, welches in Bezug auf ein Referenzpotential 18 eine Eingangsspannung 20A am ersten Gerät 10A definiert. Das Eingangssignal wird von dem ersten elektrischen Gerät 10A an den Ausgang 14 übertragen. Vorzugsweise ist der Eingang 12 direkt mit dem Ausgang 14 über eine diskrete elektrische Schaltung verbunden, wie nachfolgend noch anhand der Beschreibung eines einzelnen elektrischen Geräts erläutert wird. Das an den Ausgang 14 des ersten elektrischen Geräts 10A übertragene Eingangssignal bildet das Eingangssignal des nächsten elektrischen Geräts 10B in der Reihenschaltung. Der Ausgang 14 des ersten elektrischen Geräts 10A kann bspw. über eine elektrische Leitung mit dem Eingang 12 des nachfolgenden elektrischen Geräts 10B verbunden sein. Das Eingangssignal des elektrischen Geräts 10B wird durch eine Eingangsspannung 20B in Bezug auf das Referenzpotential 18 definiert. Die Übertragung des Eingangssignals setzt sich auf gleiche Weise fort bis zum letzten elektrischen Gerät, an dem schließlich die Eingangsspannung 20C anliegt.

In verschiedenen Ausführungen kann auch die Übertragung des Referenzpotentials 18 auf gleiche Weise erfolgen, beispielsweise über die hier dargestellten weiteren Ein- und Ausgänge 12' und 14'. Das Referenzpotential 18 kann aber auch ein gemeinsames Massepotential sein, auf das sich die einzelnen elektrischen Geräte 10 beziehen.

Die Eingangsspannungen 20A, 20B und 20C an den elektrischen Geräten 10A, 10B und 10C stehen in einer definierten Beziehung zueinander, die, wie im Folgenden aufgezeigt, durch die Übertragung des Eingangssignal von dem Eingang 12 zu dem Ausgang 14 innerhalb der elektrischen Geräte 10 definiert wird. Die Übertragung des Eingangssignals von dem Eingang 12 zu dem Ausgang 14 ist so eingerichtet, dass sich zwischen dem Eingang 12 und dem Ausgang 14 ein definierter, vorzugsweise konstanter, Spannungsabfall einstellt.

Hierfür kann zwischen Eingang 12 und Ausgang 14 ein elektrisches Bauelement 22 geschaltet sein, das den Spannungsabfall $\Delta U$ verursacht. Das elektrische Bauelement 22 kann ein passives Bauelement wie eine Diode, insbesondere eine Schottky-Diode, sein. Vorzugsweise ist der Spannungsabfall konstant und in allen elektrischen Geräten 10A, 10B und 10C gleich. Beispielsweise kann der Spannungsabfall 300 mV betragen und ist damit bezogen auf eine Eingangsspannung 20A am ersten elektrischen Gerät von industrieüblichen 24 V gering.

Ferner verfügen die elektrischen Geräte 10 über eine Messeinrichtung 24. Die Messeinrichtung 24 in den einzelnen Geräten ist dazu eingerichtet, eine gegenwärtige Spannung, die an dem elektrischen Gerät anliegt, zu messen. Die Messeinrichtung 24 kann eingangsseitig vor dem elektrischen Bauelement 22 angeordnet sein. Bevorzugt jedoch ist die Messeinrichtung 24 nach dem elektrischen Bauelement 22, d.h. ausgangsseitig, angeordnet. Die von der Messeinrichtung 24 gemessene Spannung bestimmt direkt oder indirekt eine Stellgröße des jeweiligen elektrischen Geräts. In einer Ausführungsform kann die Messeinrichtung 24 ein Analog-Digital-Konverter (ADC) sein, der einem Spannungswert einen konkreten digitalen Wert zuordnet. Der vom Analog-Digital-Konverter bestimmte Wert ist dann ein Beispiel für die Stellgröße.

Durch die Reihenschaltung der elektrischen Bauelemente 22 stellt sich ein kaskadierender Spannungsabfall über die Reihenschaltung ein. Die von der Messeinrichtung 24 gemessene Spannung ist folglich jeweils um eine Stufe niedriger als die Spannung in dem vorherigen Gerät. Aufgrund der Kaskadierung ergibt sich in jedem Gerät der Reihenschaltung ein individueller Spannungswert, der die jeweilige Stellgröße bestimmt. Bei geeigneter Wahl der elektrischen Bauelemente 22 kann erreicht werden, dass die individuellen Spannungswerte in den einzelnen elektrischen Geräten der Reihenschaltung 100 jeweils eindeutig sind. Folglich kann mit der Stellgröße dem jeweiligen elektrischen Gerät eine eindeutige Kennung innerhalb der Reihenschaltung zugeordnet werden. Wie im Nachfolgenden noch an einem konkreten Beispiel erläutert wird, kann diese eindeutige Kennung dazu verwendet werden, eine gerätespezifische Steuerfunktion auszuführen.

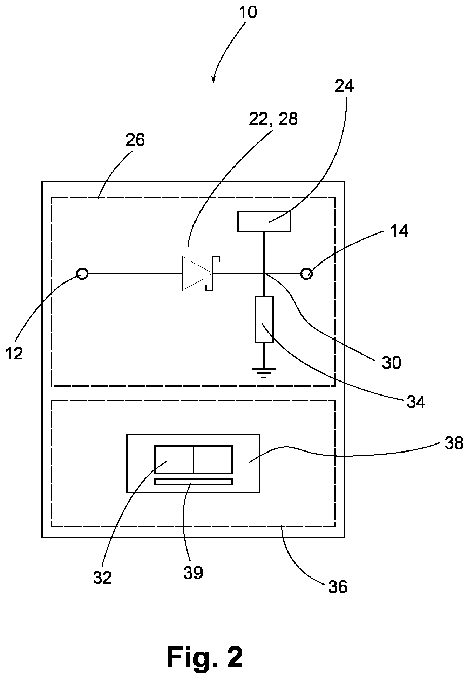

Zunächst wird jedoch in Bezug auf die Fig. 2 eine Ausführungsform einer Ein/Ausgangsschaltung 26 eines einzelnen elektrischen Geräts 10 näher beschrieben. Die Ein/Ausgangsschaltung 26 gemäß Fig. 2 ist eine elektrische Schaltung, die zwischen dem Eingang 12 und dem Ausgang 14 eines elektrischen Geräts 10, das für die Verwendung in einer Reihenschaltung hergerichtet ist, angeordnet ist. Der Eingang 12 und der Ausgang 14 sind in diesem Beispiel im Wesentlichen direkt miteinander verbunden mit lediglich einem dazwischenliegenden passiven Bauelement 22. Das passive Bauelement 22 ist in diesem konkreten Beispiel eine Schottky-Diode 28. Die Schottky-Diode 28 ist in Durchlassrichtung zwischen dem Eingang 12 und dem Ausgang 14 geschaltet und verursacht konstruktionsbedingt einen geringen Spannungsabfall $\Delta U$ zwischen dem Eingang 12 und dem Ausgang 14. Die Verwendung einer Schottky-Diode 28 hat den Vorteil, dass sich auf einfache Weise ein geringer Spannungsabfall einstellen lässt, der unter verschiedenen äußeren Einflüssen und Umgebungsbedingungen weitgehend gleichbleibt. Es versteht sich, dass der Spannungsabfall auch durch ein anderes elektrisches Bauelement realisiert werden kann.

Die Ein/Ausgangsschaltung 26 weist ferner einen Messpunkt 30 in der Verbindung zwischen Eingang 12 und Ausgang 14 auf, an den die Messeinrichtung 24 gekoppelt ist. Die Messeinrichtung 24 ist hier ein ADC eines nicht näher dargestellten Mikrocontrollers 32. Der Messpunkt 30 ist in diesem Ausführungsbeispiel ausgangsseitig, d. h. zwischen dem elektrischen Bauelement 22 und dem Ausgang 14 angeordnet. In einer anderen Ausführungsform kann der Messpunkt 30 auch vor der Diode, d. h. zur Seite des Eingangs 12 hin, angeordnet sein.

In der Ein/Ausgangsschaltung 26 ist ferner ein Widerstand 34 angeordnet. Dieser dient als Vorwiderstand für das elektrische Bauelement 22 (Diode) und bestimmt bzw. begrenzt den Strom durch das elektrische Bauelement 22 und folglich den sich einstellenden Spannungsabfall.

Im Übrigen verfügt das elektrische Gerät 10 über einen Funktionsteil 36, der die eigentliche Aufgabe des elektrischen Geräts 10 wahrnimmt. Beispielsweise kann der Funktionsteil 36 eine Verarbeitungseinheit 38 aufweisen, die eine Steuerfunktion in Abhängigkeit des am Eingang 12 anliegenden Eingangssignals ausführt. Ferner kann die Verarbeitungseinheit 38 dazu eingerichtet sein, die Steuerfunktion in Abhängigkeit der über die Messeinrichtung 24 bestimmte Stellgröße zu steuern. Bevorzugt wird somit die Steuerfunktion sowohl in Abhängigkeit des Eingangssignals als auch der bestimmten Stellgröße realisiert.

Die Verarbeitungseinheit 38 kann bspw. der Mikrocontroller 32 sein, der unter anderem auch den ADC für die Messeinrichtung 24 bereitstellt. Zudem kann die Verarbeitungseinheit 38 auch einen Speicher 39 aufweisen, in dem die zuvor ermittelte Stellgröße hinterlegbar ist. Bevorzugt jedoch wird die Stellgröße kontinuierlich bestimmt, sodass keine Speicherung der Stellgröße notwendig ist.

Es versteht sich, dass die elektrischen Geräte 10 für verschiedene Aufgaben unterschiedliche Funktionsteile 36 aufweisen können und lediglich die Ein/Ausgangsschaltungen 26 in diesen Geräten 10 identisch aufgebaut sind. Zudem ist es nicht notwendig, dass jedes Gerät 10 tatsächlich Gebrauch von der Stellgröße macht. So können sowohl Geräte 10, die auf die Stellgröße angewiesen sind, als auch andere Geräte in der Reihenschaltung gemeinsam verwendet werden.

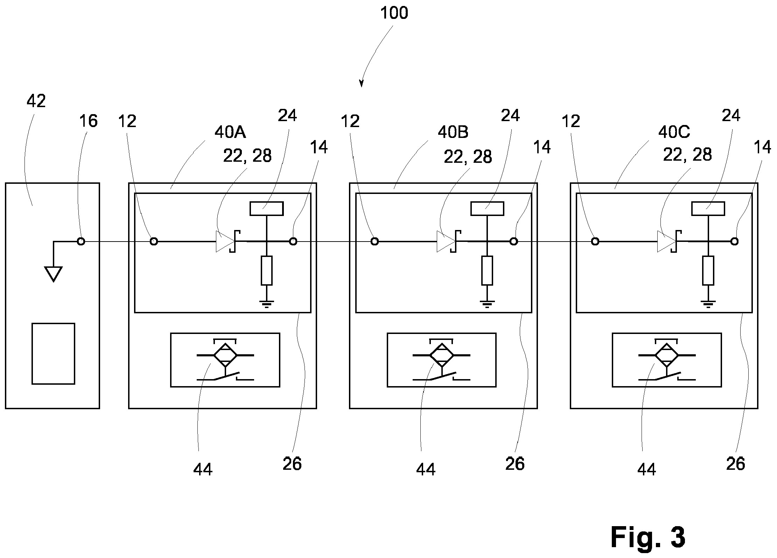

Fig. 3 zeigt ein konkretes Beispiel einer Reihenschaltung im Sinne der vorliegenden Offenbarung, bei der Verriegelungsschalter, wie sie aus der Automatisierungstechnik bekannt sind, als elektrische Geräte 10 hintereinandergeschaltet sind.

Verriegelungsschalter werden bspw. bei Maschinen und Anlagen eingesetzt, die gefahrbringende Bewegungen oder Zustände aufweisen und gemäß geltenden Vorschriften nicht ohne eine Schutzeinrichtung betrieben werden dürfen, um eine Gefährdung daran arbeitender Personen zu verhindern. Eine Maschine oder Anlage wird hierfür beispielsweise in einem umzäunten Bereich oder in einem Gehäuse angeordnet. Um trotz der trennenden Schutzeinrichtungen Arbeiten an der Maschine oder Anlage durchführen zu können oder ein Werkstück ein- bzw. ausführen zu können, wird eine Tür oder eine Abdeckung oder dergleichen vorgesehen. Hierbei muss sichergestellt sein, dass sich die Tür bzw. die Abdeckung nicht während des Betriebs der Maschine oder Anlage öffnen lässt bzw., falls dies doch versucht wird, eine Zwangsabschaltung herbeigeführt wird. Ferner sind bei Anlagen mit nachlaufenden, gefahrbringenden Bewegungen Verriegelungseinrichtungen mit Zuhaltung einzusetzen. Diese halten die Tür- bzw. die Abdeckung auch nach dem Abschalten der Maschine so lange zu, bis es zu einem Stillstand der Antriebe der Maschine oder Anlage kommt. Erst dann kann die Tür oder Abdeckung geöffnet werden.

Verriegelungsschalter werden bei technischen Anlagen häufig in einer Reihenschaltung betrieben, um einen Verkabelungsaufwand so gering wie möglich zu halten. Die Verriegelungsschalter arbeiten, wie zuvor beschrieben, einerseits als Sensor und im Falle, dass eine Zuhaltung benötigt wird, gleichzeitig als Aktor, der die Zuhaltung bewirkt. Als Aktor wird bei Verriegelungsschaltern regelmäßig ein Hubmagnet eingesetzt, der von dem Verriegelungsschalter in Abhängigkeit eines Eingangssignals schaltbar ist.

Sind mehrere Verriegelungsschalter mit Zuhaltung in einer Reihenschaltung angeordnet, kann es passieren, dass alle Aktoren gleichzeitig geschaltet werden, um die Hubmagnete anzusteuern. In diesem Fall kann es zu einem hohen Spannungsabfall in einzelnen Versorgungsleitungen kommen und dazu führen, dass die Hubmagnete nicht oder nicht zuverlässig schalten. Um dies zu vermeiden sind in den einzelnen Verriegelungsschaltern Verzögerungselemente angeordnet, die ein zeitversetztes Schalten basierend auf einem gemeinsamen Eingangssignal ermöglichen. Hierfür haben bekannte Verriegelungsschalter beispielsweise eine separate Eingangsschaltung, die von der Ausgangsschaltung im jeweiligen Gerät losgelöst ist. Ferner verfügen solche Schalter über eine Verarbeitungseinheit, die das Eingangssignal über die Eingangsschaltung aufnimmt und in Abhängigkeit davon die Ausgangsschaltung ansteuert. Hierbei ist es möglich in der Verarbeitungseinheit ein Verzögerungselement vorzusehen, welches das Weiterleiten des Eingangssignals zum Ausgang hin verzögert. Die Verarbeitungseinheit der einzelnen Verriegelungsschalter lassen sich manuell oder automatisch konfigurieren und auf die jeweilige Reihenschaltung anpassen, sodass ein zeitversetztes Schalten der Aktoren sichergestellt werden kann.

In der Fig. 3 gezeigten Ausführungsform sind drei solcher Verriegelungsschalter 40A, 40B und 40C gezeigt. Ferner zeigt Fig. 3 eine Steuerung 42, die eingerichtet ist, ein Eingangssignal an die in Reihe geschalteten Verriegelungsschalter 40A, 40B und 40C zu senden. Die Steuerung 42, beispielsweise eine Sicherheitssteuerung, überwacht den Betrieb einer technischen Anlage und steuert die Verriegelungsschalter über das Eingangssignal entsprechend an. Das Eingangssignal kann ein binäres Signal sein, das einen EIN bzw. einen AUS-Zustand einnehmen kann. In dem EIN-Zustand entspricht das Eingangssignal einem definierten Potential 16, welches am Eingang 12 des ersten Verriegelungsschalters 40A anliegt. Im AUS-Zustand liegt kein definiertes Potential am Eingang 12 an, sodass der Eingang 12 des Verriegelungsschalters 40A offen bzw. hochohmig ist. Es versteht sich, dass ein Verriegelungsschalter weitere Ein- und Ausgänge oder Schnittstellen aufweisen kann, die zur Realisierung der gewünschten Funktion relevant sein können.

Das Eingangssignal wird in der zuvor beschriebenen Weise von einem Verriegelungsschalter 40A, 40B zum nächsten Verriegelungsschalter 40B, 40C in der Reihenschaltung übertragen. Hierbei verringert sich in jedem Verriegelungsschalter 40A, 40B, 40C die Eingangsspannung um einen Betrag, der durch das elektrische Bauelement 22 definiert ist. Die Messeinrichtungen 24 in den einzelnen Verriegelungsschaltern 40A, 40B, 40C messen somit je eine verringerte Spannung gegenüber dem vorherigen Verriegelungsschaltern 40A, 40B, 40C. Über eine Zuordnungsvorschrift kann aus der gemessenen Spannung eine individuelle Stellgröße für die Verriegelungsschalter 40A, 40B, 40C generiert werden.

Die Stellgröße kann im vorliegenden Beispiel eine Zeitvariable sein, die sich bspw. aus der nachstehenden Zuordnungsvorschrift ergibt.

$$t_{Schalt,n} = f(U_{ADC,n})$$

$t_{Schalt,n}$ ist die Stellgröße des n-ten Geräts, die sich als Funktion aus der am n-ten Gerät gemessenen Spannung $U_{ADC,n}$ ergibt, bspw. in Form einer Multiplikation der gemessenen Spannung $U_{ADC,n}$ mit einem konstanten Umrechnungsfaktor. Die Stellgröße kann insbesondere eine Verzögerungszeit darstellen, die der Verriegelungsschalter 40 nach einer Veränderung am Eingang 12 abwartet, bevor der Schalter die entsprechende Steuerfunktion ausführt. Die Steuerfunktion kann bspw. das Steuern eines Magnetschalters 44 sein, wie dieser hier im Funktionsteil 36 des Verriegelungsschalters 40 angedeutet ist. Vorteilhaft kann der Verriegelungsschalter 40 somit den Schaltzeitpunkt unmittelbar aus der gemessenen Spannung ableiten, ohne dass die Stellgröße tatsächlich im Verriegelungsschalter hinterlegt werden muss.

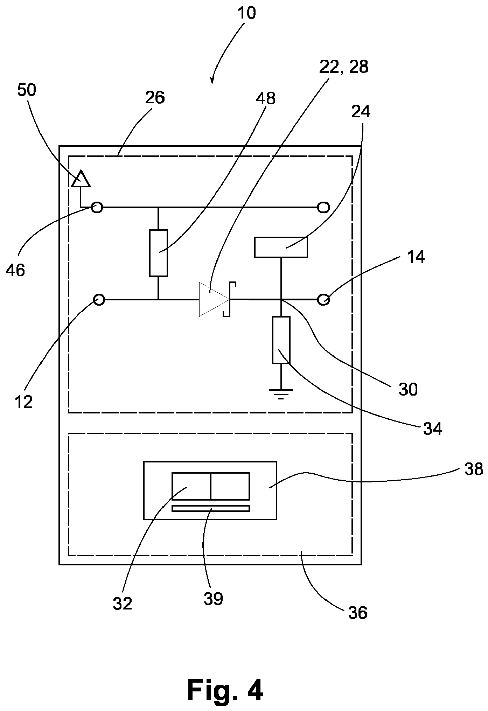

Fig. 4 zeigt eine weitere Ausführungsform eines elektrischen Geräts mit einer Weiterbildung der Ein/Ausgangsschaltung 26.

Die Ein/Ausgangsschaltung 26 weist neben den zuvor beschriebenen Elementen der Ein/Ausgangsschaltung 26 gemäß der Fig. 2 und 3 zusätzlich einen Anschluss 46 zur Aufnahme eines Versorgungspotentials 50 auf. Ferner weist die Schaltung einen weiteren Widerstand 48, der zwischen dem Anschluss 46 und dem Eingang 12 angeordnet ist, auf. Genauer gesagt, ist der Widerstand 48 als Pull-Up-Widerstand ausgebildet und einseitig mit dem Versorgungspotential 50 verbunden und auf der anderen Seite zwischen dem Eingang 12 und dem elektrischen Bauelement 22, welches den Spannungsabfall verursacht. Der Widerstand 48 kann bspw. um einen Faktor 10 bis 20 hochohmiger sein als der Widerstand 34.

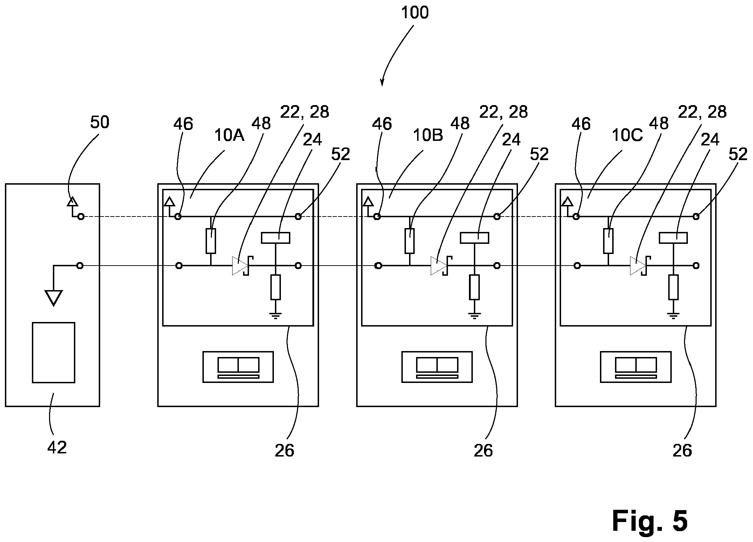

Bei der Ein/Ausgangsschaltung 26 gemäß Fig. 4 ergibt sich der Vorteil, dass auch in dem Fall, dass kein Eingangssignal am Eingang 12 anliegt und dieser somit hochohmig ist, eine durch den Pull-Up-Widerstand 48 und den Vorwiderstand 30 geteilte Spannung am elektrischen Bauelement 22 anliegt. Diese wird um die am elektrischen Bauelement 22 abfallende Spannung gemindert an dem Ausgang 14 wieder bereitgestellt und an die nachfolgenden Geräte übertragen. Folglich bildet sich auch bei der Verwendung dieser Ein/Ausgangsschaltung 26 eine Spannungskaskade über die Reihenschaltung aus, basierend auf der sich die einzelnen Geräte in der zuvor beschriebenen Weise einstellen lassen. Ein Beispiel einer entsprechenden Reihenschaltung zeigt Fig. 5.

Fig. 5 zeigt eine Reihenschaltung 100 mit drei hintereinandergeschalteten elektrischen Geräten 10A, 10B und 10C, die jeweils eine Ein/Ausgangschaltung 26 gemäß der in Fig. 4 gezeigten Ausführung aufweisen. Die elektrischen Geräte 10A, 10B und 10C können bspw. erneut die zuvor beschriebenen Verriegelungsschalter sein.

Die in Reihe geschalteten elektrischen Geräte 10A, 10B und 10C sind jeweils mit einem von der Steuerung 42 bereitgestellten Versorgungspotential 50 an dem Anschluss 46 verbunden. Das Versorgungspotential kann in einer bevorzugten Ausgestaltung ebenfalls von einem Gerät zum anderen Gerät durchgeschleift werden. Die Geräte können hierfür zusätzlich zum Anschluss 46, über den sie das Versorgungspotential 50 entgegennehmen, einen weiteren Anschluss 52 aufweisen, über den sie das Versorgungspotential 50 wieder bereitstellen.

Wie in Fig. 5 gezeigt, wird auch für den Fall, dass am ersten elektrischen Gerät 10A kein Eingangssignal am Eingang 12 anliegt und dieser offen ist, eine Spannung bereitgestellt, sodass sich auch hier eine Spannungskaskade über die Reihenschaltung ausbildet, die durch den an den elektrischen Bauelementen 22 verursachten Spannungsabfall verursacht wird. Damit ist es auch in diesem Fall möglich, über die Messeinrichtungen 24 für die einzelnen elektrischen Geräte 10A, 10B und 10C individuelle und eindeutige Spannungswerte zu bestimmen, anhand derer eine Stellgröße bestimmt werden kann. Diese Weiterbildung ermöglicht es somit, auch dann eine eindeutige Stellgröße in den elektrischen Geräten 10A, 10B und 10C zu konfigurieren, wenn am Eingang 12 des ersten Geräts der Reihenschaltung keine Eingangsspannung anliegt.

Eine Konfiguration der einzelnen elektrischen Geräte 10A, 10B und 10C kann gemäß dieser Ausgestaltung somit unabhängig von dem Vorhandensein eines Eingangssignals am Eingang 12 des ersten elektrischen Geräts erfolgen. Auf diese Weise lassen sich weitere Anwendungen realisieren.

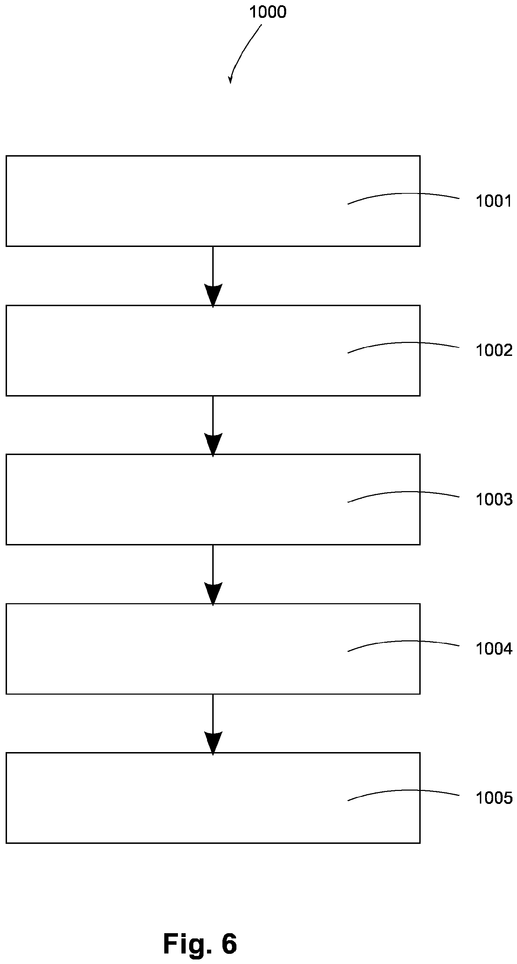

Fig. 6 zeigt in einer schematischen Darstellung ein Verfahren gemäß einer Ausführungsform der vorliegenden Offenbarung. Das Verfahren ist in seiner Gesamtheit mit der Bezugsziffer 1000 bezeichnet.

In einem ersten Schritt 1001 des Verfahrens werden zunächst die elektrischen Geräte 10 bereitgestellt. Die elektrischen Geräte 10 haben einen Eingang 12 zum Anlegen eines Eingangssignals, einen Ausgang 14 zum Bereitstellen eines Ausgangssignals sowie eine Messeinrichtung 24 zum Bestimmen einer an dem jeweiligen elektrischen Gerät 10 anliegenden Spannung.

Im nachfolgenden Schritt 1002 werden die elektrischen Geräte 10 zu einer Reihenschaltung 100 zusammengefasst, indem die Geräte 10 nacheinander in einer Kette angeordnet werden. Hierbei ist das erste Gerät mit einem Eingangssignal verbindbar und jedes weitere elektrische Gerät ist jeweils mit seinem Eingang an den Ausgang eines vorherigen elektrischen Geräts der Reihenschaltung angeschlossen.

Im Schritt 1003 wird an den Eingang des ersten elektrischen Geräts der Reihenschaltung ein definiertes Potential angelegt, welches von dem ersten Gerät an die weiteren elektrischen Geräte übertragen wird. Bei der Übertragung senkt jedes der elektrischen Geräte das definierte Potential um einen bestimmten Betrag ab (definierter Spannungsabfall), sodass sich eine Spannungskaskade über die Reihenschaltung einstellt.

Im Schritt 1004 misst jedes elektrische Gerät über die zugehörige Messeinrichtung eine Spannung, die gegenwärtige an dem jeweiligen elektrischen Gerät anliegt.

Zuletzt, im Schritt 1005, konfiguriert jedes elektrische Gerät jeweils eine für das Gerät relevante Stellgröße basierend auf der zuvor gemessenen Spannung.

Es versteht sich, dass das Verfahren weitere Schritte umfassen oder in abgewandelter Form ausgeführt werden kann. Beispielsweise kann die Bereitstellung im Schritt 1001 auch eine Rekonfiguration einer bestehenden Reihenschaltung umfassen. Bei einer Rekonfiguration können einzelne Geräte entfernt oder hinzugefügt werden. Ferner kann eine Rekonfiguration auch das Vertauschen einzelner elektrischer Geräte in der Reihenschaltung beinhalten. Auch bei einer Rekonfiguration im Schritt 1001 werden die nachfolgenden Schritte in gleicher Weise ausgeführt, um die elektrischen Geräte neu zu konfigurieren.

Denkbar ist ferner, dass die Schritte 1004 und 1005 kontinuierlich ausgeführt werden, sodass die elektrischen Geräte automatisch eine Neukonfiguration vornehmen, sobald sich die gemessene Spannung aufgrund der Spannungskaskade ändert. Diese Ausgestaltung ist auch dann von Vorteil, wenn eine Reihenschaltung, wie sie in Fig. 5 gezeigt ist, verwendet wird, bei der die Spannungskaskade sich mal basierend auf der Versorgungsspannung und mal basierend auf einem Eingangssignal einstellt. Mit anderen Worten kann es zu einer Rekonfiguration auch dann kommen, wenn kein Eingangssignal anliegt und der Eingang am ersten elektrischen Gerät offen ist. In diesem Fall tritt die Versorgungsspannung über den zusätzlichen Widerstand an die Stelle des Eingangssignals.

Der Vollständigkeit halber sei erwähnt, dass anstelle der automatischen Konfiguration es ebenso möglich ist, eine Konfiguration nur zu einem bestimmten Zeitpunkt oder in einem bestimmten Zeitfenster durchzuführen. In diesem Fall werden die Schritte 1004 und 1005 nur in dieser Zeit ausgeführt oder gegebenenfalls manuell bei der Inbetriebnahme getriggert. Hierbei ist es vorteilhaft, wenn die konfigurierte Stellgröße in einem Speicher der elektrischen Geräte hinterlegt werden kann. Die manuelle Konfiguration kann bei einer Reihenschaltung der in Fig. 2 und Fig. 3 gezeigten elektrischen Geräte vorteilhaft sein.

Es versteht sich, dass die vorstehend genannten Ausführungsbeispiele grundsätzlich nur als Beispiele zu verstehen sind, ohne den Gegenstand dieser Offenbarung dahingehend einzuschränken. Vielmehr wird der Gegenstand ausschließlich durch die nachfolgenden Ansprüche definiert und beschränkt.

**Patentansprüche**

1. Vorrichtung (100) mit einer Vielzahl von elektrischen Geräten (10; 10A, 10B, 10C), die jeweils hinsichtlich einer Stellgröße konfigurierbar sind,

   wobei die elektrischen Geräte (10; 10A, 10B, 10C) jeweils einen Eingang (12) zum Anlegen eines Eingangssignals, einen Ausgang (14) zum Bereitstellen eines Ausgangssignals sowie eine Messeinrichtung (24) zum Bestimmen einer an dem jeweiligen elektrischen Gerät (10; 10A, 10B, 10C) anliegenden Spannung, aufweisen,
   wobei die elektrischen Geräte (10; 10A, 10B, 10C) in einer Reihenschaltung anordenbar sind, bei der ein erstes elektrisches Gerät (10A) der elektrischen Geräte (10; 10A, 10B, 10C) mit einem für die Reihenschaltung maßgeblichen Eingangssignal verbindbar ist und jedes weitere elektrische Gerät (10B, 10C) jeweils mit dem Eingang (12) an den Ausgang (14) eines vorherigen elektrischen Geräts der Reihenschaltung verbunden ist,
   wobei innerhalb jedes elektrischen Geräts (10; 10A, 10B, 10C) der jeweilige Eingang (12) mit dem zugehörigen Ausgang (14) so gekoppelt ist, dass sich ein definierter Spannungsabfall zwischen dem jeweiligen Eingang (12) und dem zugehörigen Ausgang (14) einstellt, wenn an dem jeweiligen Eingang (12) ein definiertes Potential (16) anliegt, und

wobei die elektrischen Geräte (10; 10A, 10B, 10C) jeweils anhand der gemessenen anliegenden Spannung eine für das Gerät relevante Stellgröße konfigurieren.

2. Vorrichtung nach Anspruch 1, wobei das Eingangssignal einen Zustand für die Reihenschaltung repräsentiert, in dessen Abhängigkeit die elektrischen Geräte (10; 10A, 10B, 10C) eine Aktion ausführen, wobei die Aktionsausführung ferner von der konfigurierten Stellgröße abhängig ist.

3. Vorrichtung (100) nach Anspruch 2, wobei die Aktion eine Schaltfunktion gegen ein der Reihenschaltung gemeinsames Potential ist.

4. Vorrichtung (100) nach einem der Ansprüche 1 bis 3, wobei die Stellgröße eine Zeitvariable, insbesondere eine Verzögerungszeit ist.

5. Vorrichtung (100) nach einem der Ansprüche 1 bis 4, wobei zwischen dem jeweiligen Eingang (12) und dem zugehörigen Ausgang (14) der elektrischen Geräte (10; 10A, 10B, 10C) ein elektrisches Bauelement (22), insbesondere eine Schottky-Diode (28), angeordnet ist, welches den definierten Spannungsabfall zwischen dem jeweiligen Eingang (12) und dem zugehörigen Ausgang (14) verursacht.

6. Vorrichtung (100) nach einem der Ansprüche 1 bis 5, wobei zwischen dem jeweiligen Eingang (12) und dem zugehörigen Ausgang (14) der elektrischen Geräte (10; 10A, 10B, 10C) ausschließlich passive Komponenten angeordnet sind.

7. Vorrichtung (100) nach einem der Ansprüche 1 bis 6, wobei das Eingangssignal an dem jeweiligen Eingang (12) das anliegende definierte Potential (16) bereitstellt.

8. Vorrichtung (100) nach einem der Ansprüche 1 bis 7, wobei die elektrischen Geräte (10; 10A, 10B, 10C) der Reihenschaltung jeweils mit einem der Reihenschaltung gemeinsamen Referenzpotential (18) verbunden sind und der jeweilige Eingang (12) über einen ersten Widerstand (34) mit dem Referenzpotential (18) verbunden ist.

9. Vorrichtung (100) nach einem der Ansprüche 1 bis 8, wobei die elektrischen Geräte (10; 10A, 10B, 10C) der Reihenschaltung jeweils mit einem der Reihenschaltung gemeinsamen Versorgungspotential (50) verbunden sind und der jeweilige Eingang (12) über einen zweiten Widerstand (48) mit dem Versorgungspotential (50) verbunden ist.

10. Vorrichtung (100) nach Anspruch 9, wobei das Versorgungspotential (50) das an dem jeweiligen Eingang anliegende, definierte Potential (16) bereitstellt, wenn der Eingang (12) an dem ersten elektrischen Gerät (10A) hochohmig ist.

11. Vorrichtung (100) nach einem der Ansprüche 1 bis 10, wobei die elektrischen Geräte (10; 10A, 10B, 10C) Verriegelungsschalter (40) sind, insbesondere Verriegelungsschalter (40) mit Zuhaltung.

12. Elektrisches Gerät (10) einer Reihenschaltung, das hinsichtlich einer Stellgröße konfigurierbar ist, aufweisend:

einen Eingang (12) zum Anlegen eines Eingangssignals, einen Ausgang (14) zum Bereitstellen eines Ausgangssignals sowie eine Messeinrichtung (24) zum Bestimmen einer an dem elektrischen Gerät (10) anliegenden Spannung, wobei das elektrische Gerät (10) in einer Reihenschaltung anordenbar ist, bei der ein erstes elektrisches Gerät der Reihenschaltung mit einem für die Reihenschaltung maßgeblichen Eingangssignal verbindbar ist und jedes weitere elektrische Gerät der Reihenschaltung jeweils mit dem Eingang (12) an den Ausgang (14) eines vorherigen elektrischen Geräts der Reihenschaltung verbunden ist, wobei innerhalb des elektrischen Geräts (10) der Eingang (12) mit dem Ausgang (14) so gekoppelt ist, dass sich ein definierter Spannungsabfall zwischen dem Eingang (12) und dem Ausgang (14) einstellt, wenn an dem Eingang (12) ein definiertes Potential (16) anliegt, und wobei das elektrische Geräte (10) anhand der gemessenen anliegenden Spannung eine für das elektrische Gerät (10) relevante Stellgröße konfiguriert.

13. Verfahren zur Konfiguration einer Stellgröße in einer Vielzahl in Reihe geschalteter elektrischer Geräte (10; 10A, 10B, 10C), mit den Schritten:

- Bereitstellen der elektrischen Geräte (10; 10A, 10B, 10C), die jeweils einen Eingang (12) zum Anlegen eines Eingangssignals, einen Ausgang (14) zum Bereitstellen eines Ausgangssignals sowie eine Messeinrichtung (24) zum Bestimmen einer an dem jeweiligen elektrischen Gerät (10; 10A, 10B, 10C) anliegenden Spannung, aufweisen,
- Anordnen der elektrischen Geräte (10; 10A, 10B, 10C) in einer Reihenschaltung, bei der ein erstes elektrisches Gerät (10A) der elektrischen Geräte (10; 10A, 10B, 10C) mit einem für die Reihenschaltung maßgeblichen Eingangssignal verbindbar ist und jedes weitere elektrische Gerät (10B, 10C) jeweils mit seinem Eingang (12) an den Ausgang (14) eines vorherigen elektrischen Geräts der Reihenschaltung verbunden ist,

wobei jeder Eingang (12) der elektrischen Geräte (10; 10A, 10B, 10C) mit dem zugehörigen Ausgang (14) so gekoppelt ist, dass sich ein definierter Spannungsabfall zwischen dem jeweiligen Eingang (12) und dem zugehörigen Ausgang (14) einstellt, wenn an dem jeweiligen Eingang (12) ein definiertes Potential (16) anliegt,
wobei die elektrischen Geräte (10; 10A, 10B, 10C) jeweils anhand der gemessenen anliegenden Spannung eine für das Gerät relevante Stellgröße konfigurieren.

**Fig. 1**

**Fig. 2**

Fig. 3

**Fig. 4**

Fig. 5

1000

1001

1002

1003

1004

1005

Fig. 6

Europäisches Patentamt
European Patent Office
Office européen des brevets

# EUROPÄISCHER RECHERCHENBERICHT

**Nummer der Anmeldung**

EP 23 19 1462

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2013 018282 A1 (NXTCONTROL GMBH [AT]; TQ SYSTEMS GMBH [DE]) 21. Mai 2015 (2015-05-21) | 1,12,13 | INV. G05B19/042 |
| A | * Absatz [0001] – Absatz [0052]; Anspruch 1; Abbildung 1 * ----- | 2-11 | |
| A | DE 40 38 992 C1 (SIEMENS AG) 6. Februar 1992 (1992-02-06) * das ganze Dokument * ----- | 1-13 | |
| A | EP 0 348 810 A2 (SIEMENS AG [DE]) 3. Januar 1990 (1990-01-03) * das ganze Dokument * ----- | 1-13 | |

**RECHERCHIERTE SACHGEBIETE (IPC)**

G05B

Der vorliegende Recherchenbericht wurde für alle Patentansprüche erstellt

| Recherchenort | Abschlußdatum der Recherche | Prüfer |
|---|---|---|
| München | 21. Dezember 2023 | Kuntz, Jean-Marc |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 23 19 1462

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

21-12-2023

| Im Recherchenbericht angeführtes Patentdokument | Datum der Veröffentlichung | Mitglied(er) der Patentfamilie | Datum der Veröffentlichung |
|---|---|---|---|
| DE 102013018282 A1 | 21-05-2015 | DE 102013018282 A1<br>EP 2917795 A1<br>WO 2015062731 A1 | 21-05-2015<br>16-09-2015<br>07-05-2015 |
| DE 4038992 C1 | 06-02-1992 | AT E143520 T1<br>DE 4038992 C1<br>EP 0489346 A2 | 15-10-1996<br>06-02-1992<br>10-06-1992 |
| EP 0348810 A2 | 03-01-1990 | AT E101778 T1<br>EP 0348810 A2 | 15-03-1994<br>03-01-1990 |

EPO FORM P0461

Für nähere Einzelheiten zu diesem Anhang : siehe Amtsblatt des Europäischen Patentamts, Nr.12/82